# EUROPÄISCHE PATENTSCHRIFT

(11) **EP 3 386 749 B1**
(45) Veröffentlichungstag und Bekanntmachung des Hinweises auf die Patenterteilung: **29.06.2022**
(21) Anmeldenummer: 16795049.2
(22) Anmeldetag: 14.11.2016
(51) Int. Cl.: B32B 17/10, G02F 1/01

(54) **FAHRZEUG-VERBUNDSCHEIBE MIT INTEGRIERTEM LICHTSENSOR**
VEHICLE COMPOSITE PANE WITH AN INTEGRATED LIGHT SENSOR
VITRAGE FEUILLETÉ POUR VÉHICULE AVEC UN CAPTEUR DE LUMIÈRE INTEGRÉ

(30) Priorität: 07.12.2015 EP 15198195
(43) Veröffentlichungstag der Anmeldung: 17.10.2018
(73) Patentinhaber: SAINT-GOBAIN GLASS FRANCE, 92400 Courbevoie (FR)
(72) Erfinder: EFFERTZ, Christian, 52080 Aachen (DE); SCHMALBUCH, Klaus, 84220 Goult (FR); WOHLFEIL, Dirk, 4730 Raeren (BE); DUERKOP, Detlev, 50354 Hürth (DE); SCHWINGES, Guido, 52249 Eschweiler (DE); ZEISS, Michael, 52134 Herzogenrath (DE)
(74) Vertreter: Feist, Florian Arno
(86) Internationale Anmeldenummer: PCT/EP2016/077536
(87) Internationale Veröffentlichungsnummer: WO 2017/097537

(56) Entgegenhaltungen:
- DE-A1-102009 053 465
- US-A- 4 968 895
- US-A1- 2006 275 599
- US-A1- 2008 225 395
- US-A1- 2010 238 636

## Beschreibung

Die Erfindung betrifft eine Fahrzeug-Verbundscheibe mit integriertem Lichtsensor, ein Verfahren zu deren Herstellung und deren Verwendung.

Es ist bekannt, Fahrzeuge mit Lichtsensoren auszustatten, um die Menge an verfügbarem Tageslicht zu ermitteln und auf dieser Grundlage bei Bedarf die Fahrzeugscheinwerfer in Betrieb zu nehmen. Gebräuchliche Lichtsensoren sind als Anbauteile insbesondere an die innenraumseitige Oberfläche der Windschutzscheibe angebracht, beispielsweise im Bereich des Rückspiegels.

Aus EP2100722A2 ist ein Lichtsensor bekannt, welcher in eine Windschutzscheibe einlaminiert ist, also zwischen der Außenscheibe und der Innenscheibe der Windschutzscheibe angeordnet ist, welche mittels einer thermoplastischen Zwischenschicht miteinander verbunden sind. So kann die Windschutzscheibe mit dem integrierten Lichtsensor kompakt bereitgestellt werden, eine nachträgliche Montage des Lichtsensors entfällt. Der Lichtsensor ist in Form von Flip-Chip-Photodioden auf einer Leiterplatte ausgebildet.

DE102009053465A1 offenbart eine Fahrzeug-Verbundscheibe mit integrierten elektrischen Funktionselementen. Die Funktionselemente können als SMD-Bauteile auf einer Leiterplatte ausgebildet sein.

US2006275599A1 offenbart ebenfalls eine Fahrzeug-Verbundscheibe mit integrierten elektrischen Funktionselementen, insbesondere LEDs. Die Funktionselemente können als SMD-Bauteile auf einer Leiterplatte ausgebildet sein.

Der vorliegenden Erfindung liegt die Aufgabe zugrunde, eine weiter verbesserte Fahrzeugverbundscheibe mit integriertem Lichtsensor bereitzustellen.

Die Aufgabe der vorliegenden Erfindung wird erfindungsgemäß durch eine FahrzeugVerbundscheibe gemäß Anspruch 1 gelöst. Bevorzugte Ausführungen gehen aus den Unteransprüchen hervor.

Die erfindungsgemäße Fahrzeug-Verbundscheibe mit einem integrierten Lichtsensor umfasst mindestens eine Außenscheibe und eine Innenscheibe, die über eine thermoplastische Zwischenschicht miteinander verbunden sind. Die FahrzeugVerbundscheibe ist zur Abtrennung eines Fahrzeuginnenraums von einer äußeren Umgebung vorgesehen. Die Fahrzeug-Verbundscheibe ist also eine Fensterscheibe, die in eine Fensteröffnung der Fahrzeugkarosserie eingesetzt ist oder dafür vorgesehen ist. Die erfindungsgemäße Fahrzeugscheibe ist insbesondere eine Windschutzscheibe eines Kraftfahrzeugs. Mit Innenscheibe wird diejenige Scheibe bezeichnet, welche in Einbaulage dem Innenraum des Fahrzeugs zugewandt ist. Mit Außenscheibe wird diejenige Scheibe bezeichnet, welche in Einbaulage der äußeren Umgebung des Fahrzeugs zugewandt ist. Die thermoplastische Zwischenschicht ist typischerweise aus mindestens einer thermoplastischen Folie ausgebildet.

Diejenige Oberfläche der jeweiligen Scheibe, welche in Einbaulage der äußeren Umgebung des Fahrzeugs zugewandt ist, wird als außenseitige Oberfläche bezeichnet. Diejenige Oberfläche der jeweiligen Scheibe, welche in Einbaulage dem Innenraum des Fahrzeugs zugewandt ist, wird als innenraumseitige Oberfläche bezeichnet. Die innenraumseitige Oberfläche der Außenscheibe ist über die thermoplastische Zwischenschicht mit der außenseitigen Oberfläche der Innenscheibe verbunden. Üblicherweise wird die außenseitige Oberfläche der Außenscheibe als "Seite I" bezeichnet, die innenraumseitige Oberfläche der Außenscheibe als "Seite II", die außenseitige Oberfläche der Innenscheibe als "Seite III" und die innenraumseitige Oberfläche der Innenscheibe als "Seite IV".

Zwischen der Außenscheibe und der Innenscheibe sind mehrere auf einer Leiterplatte befindliche Photodioden angeordnet. Die Leiterplatte mit den Photodioden fungiert als Lichtsensor. Sie ist dazu geeignet, eine Menge an Umgebungslicht zu detektieren, wenn sie an eine entsprechende Auswerteelektronik des Fahrzeugs angeschlossen ist. In Abhängigkeit des gemessenen Umgebungslichts kann von der Auswerte- und Steuerungselektronik beispielsweise der Schaltzustand der Scheinwerfer automatisch gesteuert werden. Dadurch wird der Komfort für den Fahrzeugführer gesteigert, der nicht mehr manuell für das Ein- und Ausschalten der Scheinwerfer sorgen muss. Weitere Anwendungen sind beispielsweise die automatische elektrische Schaltung der Transmissionseigenschaften der gesamten Scheibe oder eines Scheibenbereichs und die Helligkeitsregelung von Anzeigeelementen im Fahrzeuginnenraum.

Die Photodioden sind erfindungsgemäß SMD-Bauteile. Wie dem Fachmann allgemein bekannt ist, steht die Abkürzung SMD für den Begriff *surface-mount device* (oberflächenmontiertes Bauelement). SMD-Bauteile haben keine Drahtanschlüsse, sondern werden mittels lötfähiger Anschlussflächen direkt auf die Leiterplatte gelötet. Konventionelle Bauelemente müssen durch Bestückungslöcher geführt werden und auf der Rückseite der Leiterplatte verlötet werden müssen. Dies entfällt bei SMD-Bauteilen. Dadurch werden sehr dichte Bestückungen möglich, was den Platzbedarf verringert. Verfahrenstechnisch vorteilhaft entfällt das Bohren von Löchern in die Leiterplatte. Durch den Wegfall von Anschlussdrähten und kleineren Bauteilen wird Gewicht reduziert. Die SMD-Technologie eignet sich außerdem besonders für die automatisierte Bestückung (automatisiertes Aufnehmen und Aufsetzen der Photodioden, automatisiertes Löten), was für eine industrielle Massenfertigung besonders vorteilhaft ist. SMD-Photodioden weisen typischerweise ein Gehäuse, insbesondere Kunststoffgehäuse, um den eigentlichen Chip auf, was sie beispielsweise von Flip-Chip-Photodioden unterscheidet.

Die Photodiode sollte im sichtbaren Spektralbereich empfindlich sein. Vorteilhafterweise sollte die spektrale Empfindlichkeitsverteilung an diejenige des menschlichen Auges angeglichen sein, so dass die gemessene Lichtmenge mit der von den Fahrzeuginsassen wahrgenommenen Lichtmenge möglichst gut übereinstimmt. Unerwünschte Schaltvorgänge, die durch vom Menschen nicht als relevant wahrgenommene Strahlung hervorgerufen werden, können vermieden werden, selbst bei Verwendung nur einer einzelnen Photodiode als Lichtsensor. Eine vorteilhafte Anpassung ist dann gegeben, wenn die Photodioden im gesamtem Spektralbereich zwischen 500 nm und 600 nm eine Empfindlichkeit aufweist, die mindestens 50 % ihres Empfindlichkeitsmaximums entspricht, bevorzugt mindestens 60 %. Das Empfindlichkeitsmaximum sollte im Bereich von 450 nm bis 600 nm liegen, insbesondere im Bereich von 490 nm bis 570 nm. Die Empfindlichkeit kann auch als Detektionseffizienz bezeichnet werden und kann quantifiziert werden als Anteil detektierter Photonen an der Gesamtzahl der auf die Photodiode treffenden Photonen der jeweiligen Wellenlänge. Die gewünschte spektrale Empfindlichkeit wird idealerweise durch die Art des aktiven Materials der Photodioden beeinflusst. Alternativ kann aber auch ein optischer Filter verwendet werden, um die gewünschte spektrale Empfindlichkeit zu erreichen, beispielsweise eine außenseitig zur Photodiode angeordnete Filterfolie.

Die Leiterplatte kann auch als Platine, gedruckte Schaltung oder *printed circuit board* (PCB) bezeichnet werden. Sie dient der mechanischen Befestigung und elektrischen Verbindung der darauf angeordneten Photodioden. Leiterplatten bestehen aus elektrisch isolierendem Material, insbesondere Kunststoff, mit daran haftenden, leitenden Verbindungen (Leiterbahnen). Die Leiterbahnen können lokale Verbreiterungen aufweisen, die als Lötflächen für die Bauelemente dienen.

In einer bevorzugten Ausgestaltung ist die Leiterplatte eine flexible Leiterplatte, auch als Flexleiterplatte bekannt. Solche Leiterplatten sind aus flexiblen, biegbaren Polymerfolien gebildet, beispielsweise Polyimid-Folien. Sie weisen eine Dicke von bevorzugt kleiner als 0,38 mm und größer als 50 µm auf, besonders bevorzugt von 120 µm bis 180 µm. Damit werden besonders gute Ergebnisse erreicht hinsichtlich Flexibilität einerseits und Stabilität andererseits. Durch die Flexibilität und geringe Dicke eignen sich flexible Leiterplatten besonders dafür, in eine Verbundscheibe, insbesondere gebogene Verbundscheibe einlaminiert zu werden.

Da die Photodioden SMD-Bauteile sind, wird zweckmäßigerweise eine SMD-Leiterplatte verwendet.

Die Leiterplatte kann direkt auf einer der Scheiben angeordnet sein, insbesondere mit der von den Photodioden abgewandten Seite auf der außenseitigen Oberfläche der Innenscheibe. Es hat sich gezeigt, dass die Anwesenheit der örtlich begrenzten Leiterplatte nicht zu einer wesentlichen Herabsetzung der Stabilität des Laminats führt. Die Leiterplatte kann aber auch zwischen zwei thermoplastischen Schichten, d.h. zwischen zwei Lagen der thermoplastischen Zwischenschicht angeordnet sein.

Die Leiterplatte weist mindestens zwei Anschlussflächen zur externen elektrischen Kontaktierung auf (Anode und Kathode). Diese Anschlussflächen dienen der Verbindung der Leiterplatte mit einer externen Auswerte- und Steuerungselektronik über Anschlusskabel, um den durch die Photodiode bei Lichteinfall erzeugten Stromimpuls der Auswerte- und Steuerungselektronik zuzuleiten. Die Kontaktierung der Anschlussflächen erfolgt bevorzugt mit einem Flachleiter (auch Flachbandleiter oder Folienleiter genannt), umfassend eine elektrisch leitende Folie und eine optionale, polymere Ummantelung, welche natürlich an der Anschlussstelle eine Aussparung aufweisen muss. Bevorzugt ist ein Flachleiter mit den Anschlussstellen der Leiterplatte verbunden, beispielsweise über eine Lotmasse oder einen elektrisch leitfähigen Klebstoff. Es wird bevorzugt ein mehrpoliger Flachleiter verwendet, wobei jeder Pol mit einer Anschlussfläche verbunden ist. Alternativ kann aber auch für jede Anschlussfläche ein eigener Flachleiter verwendet werden. Der Flachleiter weist an seinem von der Leiterplatte abgewandten Ende bevorzugt einen Steckverbinder auf (Stecker oder Kupplung) zur Verbindung mit weiteren Kabeln der Bordelektrik.

Die Leiterplatte ist bevorzugt vollständig im Inneren der Verbundscheibe angeordnet und mit einem Flachleiter kontaktiert, welcher sich über die Seitenkante hinaus aus der Verbundscheibe heraus erstreckt. Die Kontaktierung der Leiterplatte mit dem Flachleiter erfolgt vor der Herstellung der Verbundscheibe, bei der die Leiterplatte dann so im Verbundstapel angeordnet wird, dass sie vollständig innerhalb der Fläche der Scheiben angeordnet ist. Der Vorteil besteht in einer verringerten Bruchgefahr für die Leiterplatte, welche typischerweise anfälliger für Beschädigungen ist als der Flachleiter.

Alternativ kann sich die Leiterplatte auch aus dem Inneren der Verbundscheibe über deren Seitenkanten hinaus erstrecken, wobei die Photodioden im Inneren der Verbundscheibe angeordnet sind und die Anschlussflächen für das Anschlusskabel außerhalb der Verbundscheibe. Die Kontaktierung der Leiterplatte mit dem Anschlusskabel kann dann nach der Herstellung der Verbundscheibe erfolgen. So kann die Verbundscheibe mit dem integrierten Lichtsensor beispielsweise ohne Anschlusskabel an den Fahrzeughersteller verkauft werden, der dann vor dem Einbau der Verbundscheibe die Kontaktierung vornimmt. Natürlich kann der Flachleiter auch schon vorher mit der Leiterplatte verbunden werden und die Verbundscheibe mit integriertem Lichtsensor zusammen mit dem angeschlossenen Flachleiter bereitgestellt werden.

Leiterplatte und Flachleiter mit Steckverbinder können auch einstückig ausgebildet sein, so dass der Flachleiter gleichsam ein integraler Bestandteil der Leiterplatte ist mit einer gemeinsamen polymeren Ummantelung. Eine solche Leiterplatte hat verfahrenstechnische Vorteile, weil bei der Herstellung der Verbundscheibe das Anlöten des Flachleiters an die Anschlussflächen der Leiterplatte entfällt.

Diejenige Seitenkante, über die sich die Leiterplatte beziehungsweise ein mit ihr verbundener Flachleiter aus der Verbundscheibe hinaus erstreckt, wird im Sinne der Erfindung als diejenige Seitenkante bezeichnet, der die Leiterplatte beziehungsweise der Lichtsensor zugeordnet ist.

Erfindungsgemäß sind auf einer Leiterplatte mehrere Photodioden angeordnet, mindestens vier Photodioden, bevorzugt mindestens sechs Photodioden. Durch einen Lichtsensor basierend auf mehreren Photodioden kann die Empfindlichkeit erhöht werden. Außerdem können durch die Redundanz Fehlmessungen verringert werden und der Einsatz mehrerer Photodioden ermöglicht auch die Messung der Strahlungsrichtung des detektierten Lichts. Alle Photodioden sind auf derselben Seite der Leiterplatte angeordnet.

Erfindungsgemäß sind die Photodioden in Form von Gruppen von parallel geschalteten Photodioden auf der Leiterplatte angeordnet, wobei alle Gruppen an einen gemeinsamen elektrischen Eingang angeschlossen sind und jede Gruppe an einen separaten elektrischen Ausgang angeschlossen ist. Dadurch kann das Signal jeder Gruppe einzeln ausgelesen werden. Damit wird eine gewisse Ortsauflösung bereitgestellt, so dass im Falle eines Defekts oder einer partiellen Abschattung die betroffene Photodiodengruppe direkt identifiziert und lokalisiert werden kann. Bei einer ausreichenden Anzahl an Gruppen kann auch die Einstrahlrichtung des Lichts ermittelt werden. Besonders bevorzugt sind jeweils zwei Photodioden paarweise parallel geschaltet und der Lichtsensor weist mindestens zwei solcher Paare auf.

In einer bevorzugten Ausgestaltung sind die Photodioden in Form einer Matrix mit Zeilen und Spalten angeordnet. Die Zeilen verlaufen bevorzugt im Wesentlichen parallel zur zugeordneten Seitenkante, die Spalten im Wesentlichen senkrecht zur zugeordneten Seitenkante. Die Photodioden einer Gruppe von parallel geschalteten Photodioden sind dabei weder alle in einer Spalte noch alle in einer Reihe der Matrix angeordnet. Das bewirkt eine vorteilhafte Redundanz: die parallel geschalteten sind in einer Weise über die Leiterplatte verteilt, dass eine partielle Abschattung der Leiterplatte (beispielsweise des rechten Teils der Leiterplatte oder des unteren Teils der Leiterplatte) nur zu einer Abschattung eines Teils der parallel geschalteten Photodioden führt, so dass trotzdem ein Signal gemessen werden kann. Die Abstände benachbarter Photodioden einer Zeile beträgt bevorzugt mindestens 5 cm. Damit werden besonders gute Ergebnisse erreicht hinsichtlich der Redundanz gegenüber partieller Abschattung.

Alternativ kann es aber auch bevorzugt sein, alle Photodioden in einer Reihe anzuordnen. Dadurch kann der Lichtsensor platzsparender ausgestaltet werden, insbesondere wenn der Abstand benachbarter Photodioden höchstens 3 cm beträgt, bevorzugt höchstens 2 cm, beispielsweise von 1 cm bis 2 cm.

Die Leiterplatte weist in einer bevorzugten Ausgestaltung eine maximale Breite von mindestens 15 cm auf, bevorzugt mindestens 20 cm. Unter der Breite wird im Sinne der Erfindung die Ausdehnung im Wesentlichen parallel zu der Seitenkante bezeichnet, der der Lichtsensor zugeordnet ist. Die maximale Breite ist die größte Breite, die entlang der gesamten Länge der Leiterplatte auftritt, wenn die Breite nicht konstant ist. Anders ausgedrückt weist die Leiterplatte bevorzugt mindestens einen Abschnitt auf mit einer Breite von mindestens 15 cm, besonders bevorzugt mindestens 20 cm. Hat die Leiterplatte einen Abschnitt mit dieser Breite, so lassen sich vorteilhaft mehrere Photodioden anordnen und eine hohe Empfindlichkeit kann gewährleistet werden. Außerdem können die Photodioden ausreichend große Abstände aufweisen, so dass auch bei partieller Abschattung des Lichtsensors noch ein Signal geliefert wird. Die Photodioden sind bevorzugt in besagtem Abschnitt mit der Mindestbreite von 15 cm angeordnet, insbesondere in der vorstehend beschriebenen matrixartigen Anordnung. Die maximale Breite beträgt beispielsweise höchstens 40 cm oder 30 cm. Prinzipiell ist die Breite aber lediglich durch die Länge der zugeordneten Seitenkante begrenzt, insbesondere wenn der Randbereich mit einem durchgehenden opaken Abdeckdruck versehen ist, der die Leiterplatte entlang ihrer gesamten Breite versteckt, beziehungsweise durch technische Limitierungen bei der Herstellung der Leiterplatten.

Soll der Lichtsensor dagegen möglichst platzsparend und kostengünstig gestaltet werden, so können auch deutlich kleinere Leiterplatten verwenden werden. Die maximale Breite sollte mindestens 3 cm betragen, um sie mit ausreichend Photodioden bestücken zu können. Die maximale Breite hängt von der Anzahl und relativen Anordnung der Photodioden ab. Lichtsensoren mit ausreichender Sensitivität und geringem Platzbedarf können insbesondere mit einer maximalen Breite von 3 cm bis 10 cm erreicht werden, was daher eine weitere bevorzugte Ausgestaltung darstellt.

Die Länge der Leiterplatte beträgt in einer vorteilhaften Ausgestaltung höchstens 15 cm, bevorzugt höchstens 10 cm, besonders bevorzugt höchstens 8 cm. Unter der Länge wird im Sinne der Erfindung die Ausdehnung im Wesentlichen senkrecht zu der Seitenkante bezeichnet, der der Lichtsensor zugeordnet ist. Mit diesen maximalen Längen nimmt die Leiterplatte vorteilhaft wenig Platz in Anspruch und lässt sich hinter opaken Abdeckdrucken üblicher Breite verstecken.

Steht ein möglichst geringer Platzbedarf im Vordergrund, so kann die Leiterplatte aber auch mit einer noch deutlich geringen Länge ausgebildet sein, bevorzugt mit einer Länge von 1 cm bis 3 cm, insbesondere von 1 cm bis 2 cm.

In einer bevorzugten Ausgestaltung weist die Leiterplatte einen Endabschnitt und einen Zuleitungsabschnitt auf, wobei der Zuleitungsabschnitt eine geringere Breite aufweist als der Endabschnitt. Die Photodioden sind im Endabschnitt angeordnet und die Anschlussflächen für das Anschlusskabel im Zuleitungsabschnitt, insbesondere in der Nähe des vom Endabschnitt abgewandten Endes des Zuleitungsabschnitts. Der Zuleitungsabschnitt weist einen geringeren Abstand zur zugeordneten Seitenkante auf als der Endabschnitt und erstreckt sich bevorzugt über diese Seitenkante hinaus aus der Verbundscheibe. Eine solche Leiterplatte ist T-förmig ausgebildet, wobei der Querbalken (entspricht dem Endabschnitt) von der zugeordneten Seitenkante abgewandt ist. Der Zuleitungsabschnitt weist bevorzugt eine Länge von 1 cm bis 12 cm, besonders bevorzugt von 2 cm bis 8 cm auf. Der Zuleitungsabschnitt weist bevorzugt eine Breite von 2 cm bis 15 cm, besonders bevorzugt von 3 cm bis 10 cm auf. Der Endabschnitt weist bevorzugt eine Länge von 0,5 cm bis 3 cm auf, besonders bevorzugt von 1 cm bis 2 cm. Der Endabschnitt weist bevorzugt eine Breite von 15 cm bis 40 cm auf, besonders bevorzugt von 20 cm bis 30 cm. Mit einer solchen Leiterplatte werden besonders gute Ergebnisse erzielt hinsichtlich Effizienz und platzsparender Gestaltung. Die Photodioden sind bevorzugt im Endabschnitt der Leiterplatte angeordnet, insbesondere in der vorstehend beschriebenen matrixartigen Anordnung.

Alternativ kann die Leiterplatte aber auch rechteckig ausgestaltet sein. Sie kann dann gedanklich ebenfalls in einen Endabschnitt mit den Photodioden und einen Zuleitungsabschnitt mit den elektrischen Kontakten unterteilt werden, wobei allerdings Zuleitungs- und Endabschnitt die gleiche Breite aufweisen.

In einer vorteilhaften Ausgestaltung umfasst die Verbundscheibe mehrere Lichtsensoren, also mehrere erfindungsgemäße Leiterplatten mit mehreren Photodioden. Dies bietet zum einen den Vorteil der Redundanz: bei Ausfall eines Lichtsensors kann die Funktionalität durch den oder die anderen Lichtsensoren trotzdem sichergestellt werden. Zum anderen erlaubt die Anwesenheit mehrerer, über die Verbundscheibe verteilter Lichtsensoren die Unterscheidung zwischen einer lokalen, näherungsweise punktförmigen Strahlungsquelle wie einer Straßenlaterne und dem Umgebungslicht. Fehlinterpretationen durch die Auswerte- und Steuerungselektronik können so vermieden werden. Beispielsweise kann vermieden werden, dass eine Straßenlaterne als helles Umgebungslicht fehlinterpretiert wird und die Fahrzeugbeleuchtung infolgedessen des Nachts ausgeschaltet wird. Auch wird eine Bestimmung der Richtungsabhängigkeit der einfallenden Strahlung möglich über einen Vergleich der Intensitäten, die von den verschiedenen Lichtsensoren gemessen werden.

Durch mehrere Photodioden auf einer Leiterplatte oder durch die Verwendung mehrerer Lichtsensorelemente in einer Verbundscheibe kann die Einstrahlrichtung des detektierten Lichts bestimmt werden. Die Richtungsabhängigkeit ergibt sich aus den Intensitätsunterschieden des Messsignals der verschiedenen Photodioden beziehungsweise Lichtsensoren. Damit kann beispielsweise der aktuelle Sonnenstand ermittelt werden.

In einer bevorzugten Ausgestaltung beträgt die Breite jeder Photodiode kleiner als 2 mm. Unter der Breite wird dabei die maximale laterale Ausdehnung in einer Ebene parallel zur Leiterplatte verstanden. Mit solch vorteilhaft kleinen Photodioden ist der Lichtsensor unauffällig in die Verbundscheibe integrierbar. Eventuell nötige Löcher in einem Abdeckdruck, hinter dem der Lichtsensor versteckt werden soll, können klein und unauffällig gestaltet werden. Die Höhe der Photodioden (Ausdehnung senkrecht zur Leiterplatte) beträgt bevorzugt kleiner 0,7 mm, besonders bevorzugt kleiner 0,6 mm. Die Photodioden sind dann unter Verwendung der Standardstärke der thermoplastischen Zwischenschicht von 0,76 mm in die Verbundscheibe integrierbar.

Die Innenscheibe und die Außenscheibe bestehen bevorzugt aus Glas, besonders bevorzugt Kalk-Natron-Glas, was sich für Fenstergläser bewährt hat. Die Scheiben können aber auch aus anderen Glassorten bestehen, beispielsweise Borosilikatglas oder Aluminosilikatglas. Die Scheiben können grundsätzlich alternativ aus Kunststoff gefertigt sein, insbesondere Polycarbonat (PC) oder Polymethylmethacrylat (PMMA).

Die Dicke der Scheiben kann breit variieren und so hervorragend den Erfordernissen im Einzelfall angepasst werden. Vorzugsweise betragen die Dicken der Außenscheibe und der Innenscheibe von 0,5 mm bis 10 mm, besonders bevorzugt von 1 mm bis 5 mm, ganz besonders bevorzugt von 1,2 mm bis 3 mm.

Die Außenscheibe, die Innenscheibe oder die Zwischenschicht können klar und farblos, aber auch getönt, getrübt oder gefärbt sein. Die Gesamttransmission durch die Verbundscheibe beträgt in einer bevorzugten Ausgestaltung größer 70%, insbesondere wenn die Verbundscheibe eine Windschutzscheibe ist. Der Begriff Gesamttransmission bezieht sich auf das durch ECE-R 43, Anhang 3, § 9.1 festgelegte Verfahren zur Prüfung der Lichtdurchlässigkeit von Kraftfahrzeugscheiben. Die Außenscheibe und die Innenscheibe können aus nicht vorgespanntem, teilvorgespanntem oder vorgespanntem Glas bestehen.

Die Fahrzeugscheibe ist bevorzugt in einer oder in mehreren Richtungen des Raumes gebogen, wie es für Kraftfahrzeugscheiben üblich ist, wobei typische Krümmungsradien im Bereich von etwa 10 cm bis etwa 40 m liegen. Das Verbundglas kann aber auch plan sein, beispielsweise wenn es als Scheibe für Busse, Züge oder Traktoren vorgesehen ist.

Die Zwischenschicht enthält zumindest ein thermoplastisches Polymer, bevorzugt Ethylenvinylacetat (EVA), Polyvinylbutyral (PVB) oder Polyurethan (PU) oder Gemische oder Copolymere oder Derivate davon, besonders bevorzugt PVB. Die Zwischenschicht ist aus mindestens einer thermoplastischen Folie ausgebildet. Die Dicke einer thermoplastischen Folie beträgt bevorzugt von 0,2 mm bis 2 mm, besonders bevorzugt von 0,3 mm bis 1 mm, beispielsweise 0,38 mm oder 0,76 mm. Die Zwischenschicht kann auch aus einer sogenannten akustischen Folie ausgebildet sein, welche eine geräuschdämpfende Wirkung hat. Solche Folien bestehen typischerweise aus mindestens drei Lagen, wobei die mittlere Lage eine höhere Plastizität oder Elastizität aufweist als die sie umgebenden äußeren Lagen, beispielsweise infolge eines unterschiedlichen Anteils an Weichmachern.

Die Leiterplatte ist bevorzugt in einem nicht-transparenten Bereich der Verbundglasscheibe angeordnet, so dass sie nicht oder kaum sichtbar ist. In diesem Bereich wird die Durchsicht durch ein opakes Element verhindert. Im Fahrzeugbereich sind dafür opake Abdeckdrucke auf einer oder auf beiden Scheiben üblich. Alternativ kann die Durchsicht aber auch beispielsweise durch eine eingefärbte thermoplastische Folie der Zwischenschicht oder ein opakes Einlegeelement gehindert werden. Bevorzugt ist das opake Element innenraumseitig zum Lichtsensor angeordnet, weist also einen geringen Abstand zum Innenraum beziehungsweise zur innenraumseitigen Oberfläche der Innenscheibe auf als der Lichtsensor. Dann ist der Lichtsensor von innen nicht sichtbar, während von außen Licht auf ihn fallen kann, so dass er seine Funktion erfüllen kann. Es kann besonders bevorzugt sein, dass in Durchsichtsrichtung vor und hinter der Leiterplatte opake Elemente angebracht sind, also jeweils ein opakes Element innenraumseitig und außenseitig zum Lichtsensor. Die Leiterplatte dann weder von außen noch von innen sichtbar ist. Damit der Lichtsensor seine Funktion erfüllen kann, muss das opake Element natürlich Aussparungen an der Stelle der Photodioden aufweisen, weil eine Detektion von Licht sonst nicht möglich wäre. Ein innenraumseitig zum Lichtsensor angeordnetes opakes Element ist bevorzugt durch einen Abdeckdruck auf der Innenscheibe realisiert, ein außenseitig zum Lichtsensor angeordnetes opakes Element durch einen Abdeckdruck auf der Außenscheibe. Abdeckdrucke sind für Fahrzeugscheiben außerhalb des zentralen Sichtbereichs üblich, um Anbauteile zu verdecken oder den Klebstoff, mit dem die Fahrzeugscheibe mit der Karosserie verbunden ist, vor UV-Strahlung zu schützen. Der Abdeckdruck besteht typischerweise aus einem im Siebdruckverfahren aufgebrachten und eingebrannten schwarzen oder dunklen Emaille.

Es kann alternativ jedoch auch gewünscht sein, die Leiterplatte nicht durch einen Abdeckdruck zu verdecken, so dass sie von außen sichtbar ist. Dadurch werden insbesondere die Fertigungstoleranzen erhöht, weil die Leiterplatte nicht so exakt positioniert werden muss, um mit etwaigen Aussparungen im Schwarzdruck exakt überlagert zu sein.

Es ist auch möglich, den erfindungsgemäßen Lichtsensor mit anderen Sensoren zu kombinieren, was eine vorteilhaft platzsparende Bauweise ermöglicht. Der Lichtsensor kann beispielsweise mit einem Regensensor kombiniert werden, insbesondere einem kapazitiven Regensensor, der die Anwesenheit von Feuchtigkeit auf der Scheibe anhand einer Kapazitätsänderung mindestens einer Elektrode bestimmt wird. Die als Elektroden dienenden leitfähigen Strukturen können beispielsweise auf der Leiterplatte angeordnet sein oder auf der Innenscheibe. Der Regensensor und der Lichtsensor werden bevorzugt in räumlicher Nähe zueinander angeordnet oder räumlich überlagert, wodurch ein platzsparendes kombiniertes Sensorelement realisiert werden kann.

Die Erfindung umfasst weiter ein Verfahren zur Herstellung einer erfindungsgemäßen Fahrzeug-Verbundscheibe mit einem integrierten Lichtsensor. Dabei werden zunächst eine Außenscheibe, eine Innenscheibe, mindestens eine thermoplastische Folie und die auf einer Leiterplatte befindlichen Photodioden als Stapel angeordnet, so dass die Folie und die Photodioden zwischen der Außenscheibe und der Innenscheibe angeordnet sind. Die beiden Scheiben und die dazwischenliegende Folie oder Folien werden natürlich flächig und im Wesentlichen kongruent übereinander angeordnet. Die Leiterplatte mit den Photodioden - oder mehrere solcher Leiterplatten - ist in einen Bereich dieses Stapels eingelegt. Der Stapel wird anschließend üblichen Verfahren zur Erzeugung von Verbundscheiben unterworfen. Dabei wird die Außenscheibe über eine thermoplastische Zwischenschicht, welche während des Verfahrens aus der mindestens einen thermoplastischen Folie gebildet wird, mit der Innenscheibe durch Lamination verbunden. Dies erfolgt mit üblichen, dem Fachmann an sich bekannten Methoden, beispielsweise Autoklavverfahren, Vakuumsackverfahren, Vakuumringverfahren, Kalanderverfahren, Vakuumlaminatoren oder Kombinationen davon. Die Verbindung von Außenscheibe und Innenscheibe dabei erfolgt üblicherweise unter Einwirkung von Hitze, Vakuum und/oder Druck.

Bevorzugt wird die Leiterplatte vorher mit einem Flachleiter verbunden und dann erst im Stapel angeordnet. Bevorzugt wird sie dabei so angeordnet, dass die Leiterplatte vollständig innerhalb der Fläche der Scheiben angeordnet ist und sich der Flachleiter über deren Seitenkanten hinaus erstreckt. Die Verbindung zwischen Flachleiter und den Anschlussflächen der Leiterplatte kann beispielsweise durch Löten oder über einen elektrisch leitfähigen Klebstoff erfolgen.

Soll die Fahrzeug-Verbundscheibe eine Biegung aufweisen, wie insbesondere für Personenkraftwagen üblich, so werden die Scheiben vor dem Laminieren einem Biegeprozess unterzogen, beispielsweise durch Schwerkraftbiegen, Saugbiegen und/oder Pressbiegen. Typische Biegetemperaturen betragen von 500°C bis 700°C.

Bevorzugt wird vor dem Laminieren und vor dem optionalen Biegen ein opaker Abdeckdruck auf den Randbereich der Außenscheibe und der Innenscheibe aufgebracht. Dazu wird typischerweise eine schwarze oder dunkle Emaille per Siebdruck aufgebracht und vor dem Laminieren, insbesondere vor dem Biegen oder während des Biegens, eingebrannt.

Die Leiterplatte kann direkt auf eine der Scheiben aufgelegt werden, insbesondere mit der von den Photodioden abgewandten Seite auf die außenseitige Oberfläche der Innenscheibe. Alle Folien der Zwischenschicht werden dann auf einer Seite der Leiterplatte angeordnet.

Alternativ kann die Leiterplatte aber auch zwischen zwei thermoplastische Folien eingelegt werden, welche die Leiterplatte sandwichartig einschließen.

Es kann eine nicht weiter vorbehandelte thermoplastische Folie verwendet werden. Beim Laminieren fließt das erhitzte, fließfähige thermoplastische Material in die Räume um die Photodioden und die Leiterplatte, so dass ein stabiler Verbund sichergestellt wird.

Um die optische Qualität der Verbundscheibe zu verbessern, kann es vorteilhaft sein, die thermoplastische Folie (oder zumindest eine thermoplastische Folie bei der Verwendung von mehreren Folien) insoweit vorzubereiten, dass Aussparungen für den Lichtsensor vorgesehen werden.

Es können großflächige Löcher in der Folie erzeugt werden, in die die gesamte Leiterplatte eingesetzt wird. Bevorzugt wird die Leiterplatte dann sandwichartig von zwei dünneren Folienabschnitten umgeben, um einen Höhenunterschied zwischen Leiterplatte und Folie auszugleichen und die Haftung des Verbunds sicherzustellen.

Alternativ dazu wird in einer vorteilhaften Ausführung die thermoplastische Folie vor dem Laminieren mit Löchern oder Vertiefungen versehen. Diese Löcher oder Vertiefungen sind in Größe, Position und Anordnung auf die Photodioden abgestimmt. Das bedeutet, dass die lateralen Abmessungen der Löcher oder Vertiefungen im Wesentlichen den Abmessungen der Photodioden entspricht oder leicht größer sind, insbesondere höchsten 150% oder höchstens 120 % der Abmessungen der Photodioden betragen. Die Position der Löcher oder Vertiefungen entspricht der gewünschten Positionierung des Lichtsensors in der zu fertigenden Verbundscheibe. Die relative Anordnung der Löcher oder Vertiefungen zueinander entspricht der relativen Anordnung der Photodioden zueinander. Löcher und Vertiefungen einerseits und Photodioden andererseits stehen also gleichsam in einem Schlüssel-Schlüsselloch-Verhältnis zueinander. Beim Anordnen des Stapels zur Lamination werden die Photodioden in die Löcher oder Vertiefungen eingesetzt. So werden die Photodioden wirksam in die Zwischenschicht eingebettet. Außerdem ist die Position der Photodioden während der Produktion festgelegt, was hinsichtlich der Massenfertigung vorteilhaft ist. Die Löcher oder Vertiefungen können direkt vor dem Laminieren erzeugt werden. Die Folien mit den definierten Löchern oder Vertiefungen können aber auch in großer Stückzahl vorbereitet werden oder sogar in dieser Form vom Folienzulieferer bezogen werden.

Die Folie kann mit durchgehenden Löchern versehen werden. Weist die Folie eine Dicke auf, die größer ist als die Höhe der Photodioden, so bleibt ein eigentlich unerwünschter Hohlraum zurück. Dieser kann optional beispielsweise durch kleine Ausschnitte der thermoplastischen Folie gefüllt werden. Noch vorteilhafter, weil verfahrenstechnisch einfacher ist es, die Folie statt mit durchgehenden Löchern mit Vertiefungen zu versehen, deren Tiefe im Wesentlichen der Höhe der Photodioden entspricht. Der unerwünschte Hohlraum wird so ohne erforderliche Nacharbeit vermieden. Die Vertiefungen werden beispielsweise durch Stanzen eingebracht.

Durch die den einzelnen Photodioden zugeordneten Löcher oder Vertiefungen ist die Leiterplatte während der Herstellung an der thermoplastischen Folie fixiert. Ein zusätzliches Befestigen, beispielsweise mittels Klebebands, ist daher nicht erforderlich und wird bevorzugt nicht durchgeführt.

Die Erfindung umfasst außerdem die Verwendung einer erfindungsmäßen FahrzeugVerbundscheibe mit einem integrierten Lichtsensor als Windschutzscheibe eines Fahrzeugs, bevorzugt eines Kraftfahrzeugs, insbesondere eines Personenkraftwagens. Bevorzugt sind die Photodioden dabei mit einer Auswerte- und Steuerungselektronik des Fahrzeugs verbunden. In Abhängigkeit von dem durch die Photodioden gemessenen Umgebungslicht wird einer oder mehrere der folgenden Schaltzustände gesteuert:
- der Schaltzustand der Fahrzeugbeleuchtung (insbesondere Scheinwerfer, Schlussleuchten und Seitenmarkierungsleuchten): bei Unterschreiten eines vorbestimmten Schwellwerts wird die Beleuchtung eingeschaltet, bei Überschreiten des vorbestimmten Schwellwerts wird die Beleuchtung ausgeschaltet.
- die Transmissionseigenschaften eines Bereichs der Verbundscheibe, der mit einem elektrisch schaltbaren oder regelbaren Funktionselement ausgestattet ist. Der besagte Scheibenbereich ist insbesondere ein schalt- oder regelbarer Blendschutz im oberen Scheibendrittel (auch bekannt als *shaded band*)*.* Der Schaltzustand kann in Abhängigkeit von der absoluten Menge an Umgebungslicht geregelt werden oder auch in Abhängigkeit vom Sonnenstand, den eine ortsabhängige Messung mit mehreren Photodioden oder Lichtsensorelementen ergibt. Insbesondere bei niedrigem Sonnenstand ist der Blendschutz notwendig. Das regelbare Funktionselement kann beispielsweise ein SPD-Element (*suspended particle device*) sein oder ein LC-Element (*liquid crystal*) oder eine elektrochromes Element.

- die Intensität (Helligkeit) von Anzeigeelementen im Fahrzeuginnenraum, beispielsweise LED-Anzeigeelementen oder OLED-Anzeigeelementen. Die Anzeigeelemente sind beispielsweise Warnleuchten oder Informationsanzeigen, insbesondere in Form von Piktogrammen oder in alphanumerischer Darstellungsweise.

Die Erfindung umfasst außerdem ein Fahrzeug (nicht beansprucht), bevorzugt Kraftfahrzeug, insbesondere Personenkraftwagen, mit einer erfindungsgemäßen Verbundscheibe als Windschutzscheibe und einer Auswerte- und Steuerungselektronik, die einerseits mit den Photodioden verbunden ist und andererseits mit
- der Fahrzeugbeleuchtung, um den Schaltzustand der Fahrzeugbeleuchtung in Abhängigkeit von dem durch die Photodioden gemessenen Umgebungslicht zu steuern;
- einem elektrisch schaltbaren oder regelbaren Funktionselement, das in einem Bereich der Verbundscheibe angeordnet ist, um den Transmissionseigenschaften des besagten Bereichs in Abhängigkeit von dem durch die Photodioden gemessenen Umgebungslicht zu steuern, wobei es sich bei dem besagten Bereich bevorzugt um einen schalt- oder regelbaren Blendschutz im oberen Scheibendrittel handelt; und/oder
- Anzeigeelementen im Fahrzeuginnenraum, um deren Intensität (Helligkeit) in Abhängigkeit von dem durch die Photodioden gemessenen Umgebungslicht zu steuern.

Im Folgenden wird die Erfindung anhand einer Zeichnung und Ausführungsbeispielen näher erläutert. Die Zeichnung ist eine schematische Darstellung und nicht maßstabsgetreu.

Es zeigen:
- Fig. 1: eine Draufsicht auf eine Ausgestaltung einer gattungsgemäßen Fahrzeug-Verbundscheibe,
- Fig. 2: eine vergrößerte Darstellung des Ausschnitts Z aus Fig. 1 mit einem Lichtsensor (nicht beansprucht),
- Fig. 3: einen Querschnitt entlang A-A' durch die Fahrzeug-Verbundscheibe aus Fig. 1,
- Fig. 4: ein Schaltbild des Lichtsensors aus Fig. 2 (nicht beansprucht),
- Fig. 5: eine erfindungsgemäße Ausgestaltung des Lichtsensors,
- Fig. 6: ein Schaltbild des Lichtsensors aus Fig. 5 und
- Fig. 7: ein Flussdiagramm einer Ausführungsform des erfindungsgemäßen Verfahrens.

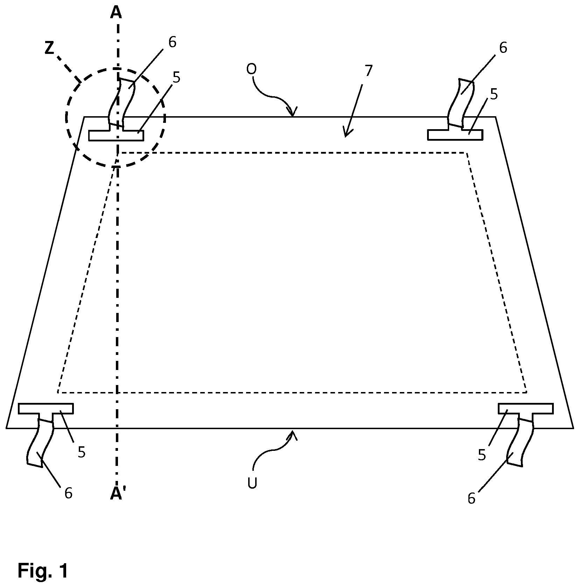

Fig. 1, Fig. 2 und Fig. 3 zeigen je ein Detail einer Fahrzeug-Verbundscheibe mit integriertem Lichtsensor, die als solche nicht beansprucht wird. Die Verbundscheibe ist aufgebaut aus einer Außenscheibe 1 (mit einer außenseitigen Oberfläche I und einer innenraumseitigen Oberfläche II) und einer Innenscheibe 2 (mit einer außenseitigen Oberfläche III und einer innenraumseitigen Oberfläche IV), die über eine thermoplastische Zwischenschicht 3 flächig miteinander verbunden sind. Die Außenscheibe 1 und die Innenscheibe 2 bestehen aus Kalk-Natron-Glas und weisen beispielsweise eine Dicke von 2,1 mm auf. Die Zwischenschicht 3 ist aus einer 0,76 mm dicken Folie aus Polyvinylbutyral (PVB) ausgebildet. Die Verbundscheibe ist als Windschutzscheibe eines Kraftfahrzeugs vorgesehen.

Die Verbundscheibe ist mit vier Lichtsensoren ausgestattet. Jeder Lichtsensor besteht aus einer flexiblen Leiterplatte 5, die mit jeweils sechs SMD-Photodioden 4 ausgestattet ist. Jeder Lichtsensor ist beispielhaft in einem Eckbereich der Verbundscheibe angeordnet, wobei zwei Lichtsensoren der Oberkante O und zwei Lichtsensoren der Unterkante U der Verbundscheibe zugeordnet sind. Die Leiterplatte 5 ist vollständig innerhalb der Verbundscheibe angeordnet. Sie liegt direkt auf der außenseitigen Oberfläche III der Innenscheibe 2 auf und ist über die Zwischenschicht 3 mit der Außenscheibe verbunden. Sie weist zwei elektrische Anschlussflächen (nicht dargestellt) auf, die mit jeweils einem Pol eines zweipoligen Flachleiters als Anschlusskabel 6 verlötet sind. Das Anschlusskabel 6 erstreckt sich aus dem Verbund über die jeweilige zugeordnete Kante O, U hinaus. Die Anschlusskabel 6 dienen der elektrischen Verbindung der Leiterplatten 5 über weitere Verbindungskabel (typischerweise Rundkabel) mit einer Auswerte- und Steuerungselektronik als Teil der Fahrzeug-Bordelektronik. Die Auswerte- und Steuerungselektronik analysiert die Signale der Lichtsensoren - so kann die Auswerte- und Steuerungselektronik beispielsweise die Fahrzeugbeleuchtung in Abhängigkeit von der durch die Lichtsensoren bestimmte Menge an Umgebungslicht ein- beziehungsweise ausschalten.

Durch die Mehrzahl an Lichtsensoren kann das System unterscheiden zwischen dem Umgebungslicht, das von allen Lichtsensoren im Wesentlichen mit gleicher Intensität gemessen wird, und einer lokalen Lichtquelle wie einer Straßenlaterne, welche von den verteilten Lichtsensoren mit stark unterschiedlicher Intensität gemessen wird. Deutlich kleinere Intensitätsunterschiede können bei geeigneter Auswerteelektronik herangezogen werden zur Bestimmung des Sonnenstands: das Verhältnis der Lichtintensitäten, die von den Lichtsensoren an der Oberkante O einerseits und denjenigen an der Unterkante U andererseits detektiert werden, hängt vom Sonnenstand ab, also vom Winkel, unter dem die Strahlung auf die Verbundscheibe trifft.

Als Photodioden 4 sind beispielsweise Photodioden des Typs APDS-9005 der Firma *Avago Technologies* geeignet. Sie weisen vorteilhaft geringe Abmessungen auf (Höhe 0,55 mm, Breite 1,6 mm, Tiefe 1,5 mm) und eine spektrale Empfindlichkeitsverteilung, die diejenige des menschlichen Auges in guter Näherung nachahmt. Das Empfindlichkeitsmaximum liegt ungefähr bei 500 nm, und im gesamten Bereich von 500 nm bis 600 nm beträgt die Empfindlichkeit mehr als 60 % des Maximalwerts bei 500 nm. Dadurch wird sichergestellt, dass die vom Lichtsensor gemessene Lichtmenge auch mit der vom Menschen als relevant eingestuften übereinstimmt.

Die Leiterplatte 5 ist eine flexible Leiterplatte, umfassend eine etwa 150 µm dicke PolyimidFolie und darauf aufgedruckte Leiterbahnen 8. Jede Leiterplatte 5 ist T-förmig gestaltet und weist einen dünneren Zuleitungsabschnitt und einen breiten Endabschnitt (endsprechend dem "Querbalken des T"s) auf, wobei der Zuleitungsabschnitt der zugeordneten Kante O, U zugewandt ist. Der Zuleitungsabschnitt hat beispielsweise eine Breite von 50 mm und eine Länge von 65 mm. Der Endabschnitt hat beispielsweise eine Breite von 200 mm und eine Länge von 15 mm. Alle Photodioden 4 einer Leiterplatte sind im Endabschnitt angeordnet, während der Zuleitungsabschnitt der Verbindung mit dem Anschlusskabel 6 dient. Am Ende des Zuleitungsabschnitts sind zwei nicht dargestellte Anschlussflächen angeordnet, die den beiden Polen des Systems an Leiterbahnen 8 entsprechen und die jeweils mit einem Pol des zweipoligen Anschlusskabels 6 verlötet sind.

Jede Leiterplatte 5 ist mit sechs Photodioden 4 ausgestattet. Die Photodioden sind matrixartig in 2 Zeilen und 3 Spalten angeordnet. Durch die Leiterbahnen 8 auf der Leiterplatte 5 sind die Photodioden 4 miteinander verschaltet. Jede Photodiode 4 weist zwei Anschlussflächen auf (*in*/*out*)*,* die jeweils auf eine Leiterbahn 8 aufgelötet sind.

Jeweils zwei Photodioden 4 sind parallel geschaltet, und die drei parallel geschalteten Paare sind in Reihe geschaltet. Im dargestellten Beispiel sind die Photodioden 4.1 und 4.2 parallel geschaltet, ebenso wie die Photodioden 4.3 und 4.4 und ebenso wie die Photodioden 4.5 und 4.6. Die beiden Photodioden eines parallel geschalteten Paars sind jeweils in unterschiedlichen Reihen und Spalten der Matrix angeordnet. So wird sichergestellt, dass auch bei partieller Abschattung der Leiterplatte, beispielsweise des rechten Bereichs mit den Photodioden 4.2 und 4.5, immer mindestens eine Photodiode jedes Paars vom Licht beschienen wird und somit trotz der partiellen Abschattung insgesamt ein Lichtsignal gemessen wird. Der Abstand benachbarter Photodioden 4 in den Zeilen beträgt beispielsweise 9 cm, in den Spalten beispielsweise 1 cm.

Die Verbundscheibe weist, wie für Windschutzscheiben üblich, einen rahmenartigen opaken Abdeckdruck 7 auf. Der Abdeckdruck 7 ist als aufgedruckte und eingebrannte, schwarze Emaille auf den innenraumseitigen Oberflächen II, IV der Außenscheibe 1 und der Innenscheibe 2 ausgebildet. Die Leiterplatten 5 sind im Bereich des Abdeckdrucks 7 angeordnet, so dass sie weder von außen noch von innen sichtbar sind. Der äußere Abdeckdruck 7 auf der Außenscheibe 1 weist an den Stellen der Photodioden 4 Löcher auf, so dass Licht auf die Photodioden 4 fallen kann und der Lichtsensor seine Funktion erfüllen kann.

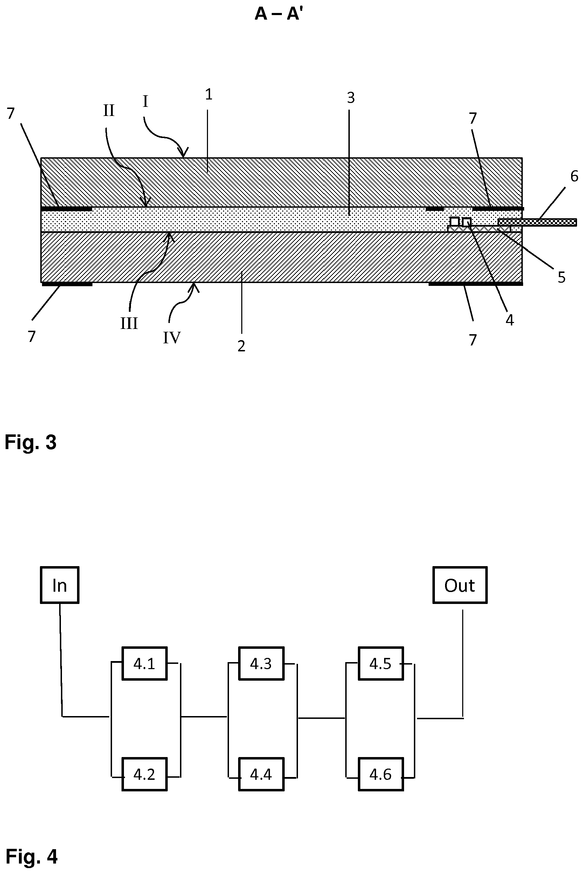

Fig. 4 zeigt einen schematischen Schaltplan des vorstehend beschriebenen Lichtsensors (nicht beansprucht). Aus dem Schaltplan wird die serielle Verschaltung der Gruppen von parallel geschalteten Photodioden deutlich. Die Gesamtheit der Photodioden ist an einen gemeinsamen elektrischen Eingang und einen gemeinsamen elektrischen Ausgang angeschlossen und liefert ein einziges, gemeinsames Signal (Gruppensignal).

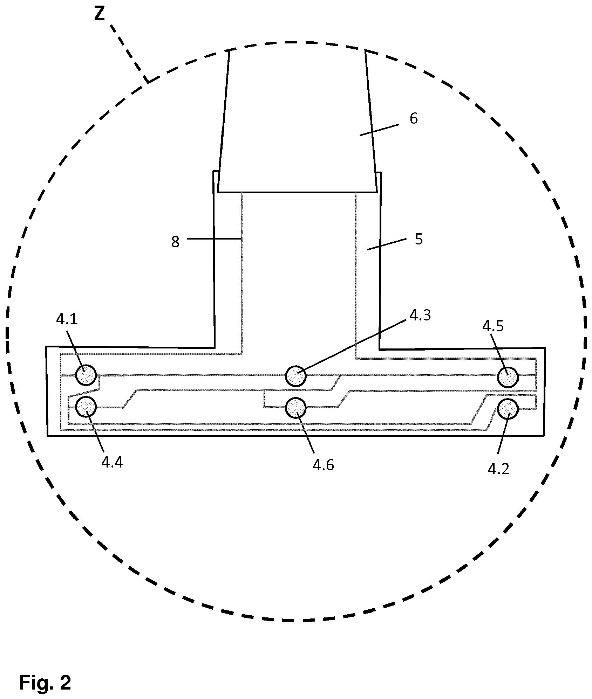

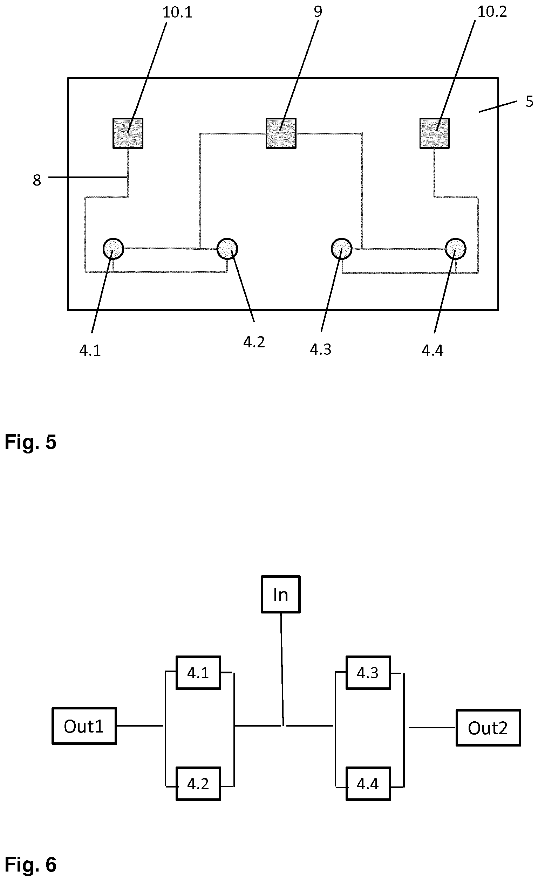

Fig. 5 zeigt eine Ausgestaltung des Lichtsensors, die eine erfindungsgemäße Alternative zur Ausgestaltung der Figur 2 darstellt. Die Leiterplatte 5 ist eine flexible Leiterplatte mit darauf aufgedruckten Leiterbahnen 8. Die Leiterplatte 5 ist rechteckig ausgestaltet mit einer Breite von 42 mm und einer Höhe von 14 mm. Vier Photodioden 4.1, 4.2, 4.3, 4.4 sind in einer Reihe angeordnet. Die Photodioden 4.1 und 4.2 sind parallel geschaltet, ebenso wie die Photodioden 4.3 und 4.4. Beide Gruppen sind mit einer gemeinsamen Anschlussfläche 9 für den elektrischen Eingang angeschlossen, aber jede Gruppe ist an eine separate Anschlussfläche 10.1, 10.2 für den elektrischen Ausgang angeschlossen. Die beiden Gruppen parallel geschalteter Photodioden können so unabhängig voneinander durch die Auswerteelektronik ausgelesen werden und liefern jeweils ein separates Signal.

Durch diese Art der Verschaltung wird eine höhere Empfindlichkeit erreicht. Außerdem ist im Falle eines geringeren Signals einer Gruppe direkt lokalisierbar, wo der Defekt, die Abschattung oder Ähnliches auftritt, so dass ein gewisse Ortsauflösung bereitgestellt wird.

Der Lichtsensor ist um weitere Gruppen parallel geschalteter Photodioden erweiterbar, beispielsweise um die Empfindlichkeit, die Redundanz oder die Ortsauflösung zu verbessern, oder um die Einstrahlrichtung des detektierten Lichts bestimmen zu können.

Fig. 6 zeigt einen schematischen Schaltplan des Lichtsensors aus Fig. 5.

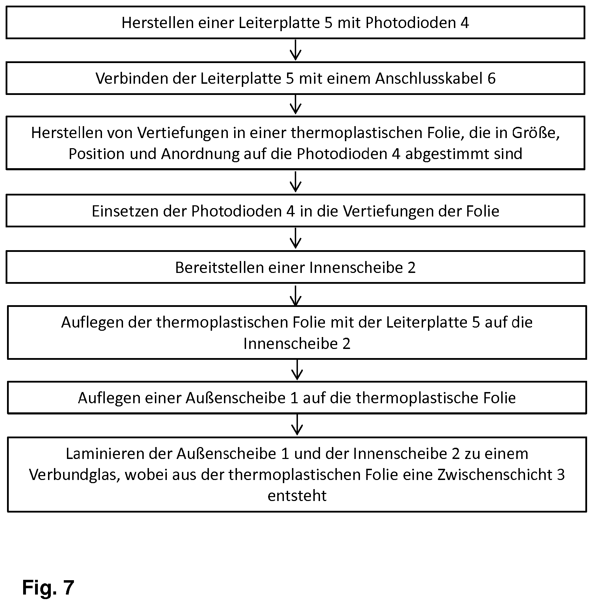

Fig. 7 zeigt ein Flussdiagramm eines Ausführungsbeispiels des erfindungsgemäßen Verfahrens zur Herstellung einer Fahrzeug-Verbundscheibe mit einem integrierten Lichtsensor.

### Bezugszeichenliste:

- (1): Außenscheibe
- (2): Innenscheibe
- (3): thermoplastische Zwischenschicht
- (4): Photodiode
- (4.1), (4.2), (4.3), (4.4), (4.5), (4.6): Photodioden
- (5): Leiterplatte (*printed circuit board,* PCB)
- (6): Anschlusskabel / Flachleiter
- (7): opaker Abdeckdruck
- (8): Leiterbahn
- (9): Anschlussfläche der Leiterplatte (elektrischer Eingang)
- (10.1), (10.2): Anschlussfläche der Leiterplatte (elektrischer Ausgang)

- (In): elektrischer Eingang
- (Out): elektrischer Ausgang (zur Auswerteelektronik)
- (Out1), (Out2): elektrische Ausgänge (zur Auswerteelektronik)

- (O): Oberkante der Verbundscheibe
- (U): Unterkante der Verbundscheibe

- (I): außenseitige Oberfläche der Außenscheibe 1
- (II): innenraumseitige Oberfläche der Außenscheibe 1
- (III): außenseitige Oberfläche der Innenscheibe 2
- (IV): innenraumseitige Oberfläche der Innenscheibe 2

- A-A': Schnittlinie
- Z: vergrößerter Ausschnitt

## Patentansprüche

1. Fahrzeug-Verbundscheibe mit einem integrierten Lichtsensor, mindestens umfassend eine Außenscheibe (1), eine Innenscheibe (2), die über eine thermoplastische Zwischenschicht (3) miteinander verbunden sind,
wobei zwischen der Außenscheibe (1) und der Innenscheibe (2) mehrere auf einer Leiterplatte (5) befindliche Photodioden (4) angeordnet sind,
wobei die Photodioden (4) SMD-Bauteile sind,
und wobei die Photodioden (4) als Gruppen von parallel geschalteten Photodioden (4) auf der Leiterplatte (5) angeordnet sind, wobei alle Gruppen an einen gemeinsamen elektrischen Eingang (9) angeschlossen sind und jede Gruppe an einen separaten elektrischen Ausgang (10.1, 10.2) angeschlossen ist.

2. Fahrzeug-Verbundscheibe nach Anspruch 1, wobei die Leiterplatte (5) als flexible Leiterplatte ausgebildet ist.

3. Fahrzeug-Verbundscheibe nach Anspruch 1 oder 2, wobei jeweils zwei Photodioden (4) parallel geschaltet sind und mindestens zwei solcher Paare vorhanden sind.

4. Fahrzeug-Verbundscheibe nach Anspruch 3, wobei die Photodioden (4) in einer Reihe angeordnet sind.

5. Fahrzeug-Verbundscheibe nach Anspruch 4, wobei der Abstand benachbarter Photodioden (4) höchstens 3 cm beträgt.

6. Fahrzeug-Verbundscheibe nach einem der Ansprüche 1 bis 5, wobei die Leiterplatte (5) eine Breite von 3 cm bis 10 cm aufweist und bevorzugt eine Länge von 1 cm bis 3 cm .

7. Fahrzeug-Verbundscheibe nach einem der Ansprüche 1 bis 6, wobei die Photodioden (4) im gesamtem Spektralbereich zwischen 500 nm und 600 nm eine Empfindlichkeit aufweisen, die mindestens 50 % des Empfindlichkeitsmaximums entspricht, bevorzugt mindestens 60 %.

8. Fahrzeug-Verbundscheibe nach einem der Ansprüche 1 bis 7, wobei die Verbundscheibe mehrere Leiterplatten (5) mit Photodioden (4) umfasst, wobei die Photodioden (4) SMD-Bauteile sind und wobei die Photodioden (4) als Gruppen von parallel geschalteten Photodioden (4) auf der Leiterplatte (5) angeordnet sind, wobei alle Gruppen an einen gemeinsamen elektrischen Eingang (9) angeschlossen sind und jede Gruppe an einen separaten elektrischen Ausgang (10.1, 10.2) angeschlossen ist.

9. Fahrzeug-Verbundscheibe nach einem der Ansprüche 1 bis 8, wobei die Photodioden (4) eine Breite von kleiner als 2 mm aufweisen.

10. Verfahren zur Herstellung einer Fahrzeug-Verbundscheibe mit einem integrierten Lichtsensor nach einem der Ansprüche 1 bis 9, wobei
(a) eine Außenscheibe (1), eine Innenscheibe (2), mindestens eine thermoplastische Folie und die auf einer Leiterplatte (5) befindlichen Photodioden (4) als Stapel angeordnet werden, so dass die Folie und die Photodioden (4) zwischen der Außenscheibe (1) und der Innenscheibe (2) angeordnet sind.
(b) die Außenscheibe (1) über eine aus der mindestens einen thermoplastischen Folie gebildeten Zwischenschicht (3) mit der Innenscheibe (2) durch Lamination verbunden wird.

11. Verfahren nach Anspruch 10, wobei die Folie vor Schritt (a) mit Löchern oder Vertiefungen versehen wird, welche in Größe, Position und Anordnung auf die Photodioden (4) abgestimmt sind und in welche die Photodioden (4) während Schritt (a) eingesetzt werden.

12. Verwendung einer Fahrzeug-Verbundscheibe mit einem integrierten Lichtsensor nach einem der Ansprüche 1 bis 9 als Windschutzscheibe eines Fahrzeugs, bevorzugt eines Kraftfahrzeugs.

13. Verwendung nach Anspruch 12, wobei die Photodioden mit einer Auswerte- und Steuerungselektronik des Fahrzeugs verbunden sind und der Schaltzustand der Fahrzeugbeleuchtung, die Transmissionseigenschaften eines Scheibenbereichs und/oder die Intensität von Anzeigeelementen im Fahrzeuginnenraum in Abhängigkeit von dem durch die Photodioden (4) gemessenen Umgebungslicht gesteuert wird.

## Claims

1. Vehicle composite pane with an integrated light sensor, at least comprising an outer pane (1) [and] an inner pane (2) that are bonded to one another via a thermoplastic intermediate layer (3),
wherein a plurality of photodiodes (4) situated on a circuit board (5) are arranged between the outer pane (1) and the inner pane (2),
wherein the photodiodes (4) are SMD components,
and wherein the photodiodes (4) are arranged on the circuit board (5) as groups of parallel connected photodiodes (4), wherein all groups are connected to a common electrical input (9) and each group is connected to a separate electrical output (10.1, 10.2).

2. Vehicle composite pane according to claim 1, wherein the circuit board (5) is implemented as a flexible circuit board.

3. Vehicle composite pane according to claim 1 or 2, wherein, in each case, two photodiodes (4) are connected in parallel and at least two such pairs are present.

4. Vehicle composite pane according to claim 3, wherein the photodiodes (4) are arranged in a row.

5. Vehicle composite pane according to claim 4, wherein the distance between adjacent photodiodes (4) is at most 3 cm.

6. Vehicle composite pane according to one of claims 1 through 5, wherein the circuit board (5) has a width of 3 cm to 10 cm and preferably a length of 1 cm to 3 cm.

7. Vehicle composite pane according to one of claims 1 through 6, wherein the photodiodes (4) have, in the entire spectral range between 500 nm and 600 nm, sensitivity that corresponds to at least 50% of the maximum sensitivity, preferably at least 60% %.

8. Vehicle composite pane according to one of claims 1 through 7, wherein the composite pane includes a plurality of circuit boards (5) with photodiodes (4) wherein the photodiodes (4) are SMD components, and wherein the photodiodes (4) are arranged on the circuit board (5) as groups of parallel connected photodiodes (4), wherein all groups are connected to a common electrical input (9) and each group is connected to a separate electrical output (10.1, 10.2).

9. Vehicle composite pane according to one of claims 1 through 8, wherein the photodiodes (4) have a width of less than 2 mm.

10. Method for producing a vehicle composite pane with an integrated light sensor according to one of claims 1 through 9, wherein
(a) an outer pane (1), an inner pane (2), at least one thermoplastic film, and the photodiodes (4) situated on a circuit board (5) are arranged as a stack such that the film and the photodiodes (4) are arranged between the outer pane (1) and the inner pane (2).
(b) the outer pane (1) is bonded, by lamination, to the inner pane (2) via an intermediate layer (3) formed from the at least one thermoplastic film.

11. Method according to claim 10, wherein, before step (a), the film is provided with holes or indentations that are coordinated in size, position, and arrangement with the photodiodes (4) and into which the photodiodes (4) are inserted during step (a).

12. Use of a vehicle composite pane with an integrated light sensor according to one of claims 1 through 9 as a windshield of a vehicle, preferably a motor vehicle.

13. Use according to claim 12, wherein the photodiodes are connected to evaluation and control electronics of the vehicle, and the switching state of the vehicle lighting, the transmittance properties of a pane region, and/or the intensity of display elements in the vehicle interior is controlled as a function of the ambient light measured by the photodiodes (4).

## Revendications

1. - Vitre feuilletée pour véhicule ayant un capteur de lumière intégré, comprenant au moins une plaque externe (1), une plaque interne (2), qui sont reliées l'une à l'autre par une couche intermédiaire thermoplastique (3), plusieurs photodiodes (4) se trouvant sur une carte de circuits imprimés (5) étant disposées entre la plaque externe (1) et la plaque interne (2),
les photodiodes (4) étant des composants montés en surface (CMS),
et les photodiodes (4) étant disposées sur la carte de circuits imprimés (5) sous la forme de groupes de photodiodes (4) montées en parallèle, tous les groupes étant raccordés à une entrée électrique commune (9) et chaque groupe étant raccordé à une sortie électrique séparée (10.1 , 10.2).

2. - Vitre feuilletée pour véhicule selon la revendication 1, dans laquelle la carte de circuits imprimés (5) est conçue comme carte de circuits imprimés flexible.

3. - Vitre feuilletée pour véhicule selon l'une des revendications 1 ou 2, dans laquelle à chaque fois deux photodiodes (4) sont montées en parallèle et au moins deux telles paires sont présentes.

4. - Vitre feuilletée pour véhicule selon la revendication 3, dans laquelle les photodiodes (4) sont disposées en une rangée.

5. - Vitre feuilletée pour véhicule selon la revendication 4, dans laquelle la distance entre des photodiodes (4) voisines est d'au plus 3 cm.

6. - Vitre feuilletée pour véhicule selon l'une des revendications 1 à 5, dans laquelle la carte de circuit imprimé (5) présente une largeur de 3 cm à 10 cm et, de préférence, une longueur de 1 cm à 3 cm .

7. - Vitre feuilletée pour véhicule selon l'une des revendications 1 à 6, dans laquelle les photodiodes (4) présentent, dans l'ensemble du domaine spectral entre 500 nm et 600 nm, une sensibilité qui correspond à au moins 50 % du maximum de sensibilité, de préférence à au moins 60 %.

8. - Vitre feuilletée pour véhicule selon l'une des revendications 1 à 7, dans laquelle la vitre feuilletée comporte plusieurs cartes de circuits imprimés (5) ayant des photodiodes (4), les photodiodes (4) étant des composants montés en surface (CMS) et les photodiodes (4) étant disposées sur la carte de circuits imprimés (5) sous la forme de groupes de photodiodes (4) montées en parallèle, tous les groupes étant raccordés à une entrée électrique commune (9) et chaque groupe étant raccordé à une sortie électrique séparée (10.1 , 10.2).

9. - Vitre feuilletée pour véhicule selon l'une des revendications 1 à 8, dans laquelle les photodiodes (4) présentent une largeur de moins de 2 mm.

10. - Procédé de fabrication d'une vitre feuilletée pour véhicule ayant un capteur de lumière intégré selon l'une des revendications 1 à 9, dans lequel
(a) une plaque externe (1), une plaque interne (2), au moins une feuille thermoplastique et les photodiodes (4) se trouvant sur une carte de circuits imprimés (5) sont disposées sous forme d'empilement, de telle sorte que la feuille et les photodiodes (4) sont disposées entre la plaque externe (1) et la plaque interne (2) ;
(b) la plaque externe (1) est reliée à la plaque interne (2) par stratification par l'intermédiaire d'une couche intermédiaire (3) formée de ladite au moins une feuille thermoplastique.

11. - Procédé selon la revendication 10, dans lequel, avant l'étape (a), la feuille est pourvue de trous ou de cavités dont la taille, la position et la disposition sont adaptées aux photodiodes (4) et dans lesquels (lesquelles) les photodiodes (4) sont introduites pendant l'étape (a).

12. - Utilisation d'une vitre feuilletée pour véhicule ayant un capteur de lumière intégré selon l'une des revendications 1 à 9 comme pare-brise d'un véhicule, de préférence d'un véhicule automobile.

13. - Utilisation selon la revendication 12, dans laquelle les photodiodes sont reliées à une électronique d'évaluation et de commande du véhicule et l'état de commutation de l'éclairage du véhicule, les propriétés de transmission d'une zone de vitre et/ou l'intensité d'éléments d'affichage dans l'espace intérieur du véhicule sont commandés en fonction de la lumière ambiante mesurée par les photodiodes (4).
